# EUROPEAN PATENT APPLICATION

(11) **EP 4 534 612 A1**
(43) Date of publication of application: **09.04.2025**
(21) Application number: 23816264.8
(22) Date of filing: 17.05.2023
(51) Int. Cl.: C09D 1/00, C09D 7/20, C09D 7/61, C09D 7/63, C09D 5/32, C09K 11/66, C09K 11/02, C01G 21/00, H10K 30/10, H10K 30/30

(54) **COATING AGENT FOR FORMING LARGE-AREA PEROVSKITE THIN FILM AND METHOD FOR FORMING PEROVSKITE THIN FILM USING SAME**

(30) Priority: 31.05.2022 KR 20220066577
(71) Applicant: Hanwha Solutions Corporation, Jung-gu Seoul 04541 (KR)
(72) Inventor: LIM, Kwang Soo, Seoul 04541 (KR); HWANG, Kyeongil, Seoul 04541 (KR)
(74) Representative: Mooser, Sebastian Thomas
(86) International application number: PCT/KR2023/006674
(87) International publication number: WO 2023/234601

(57) **Abstract**

The present invention pertains to: a method for forming a large-area perovskite thin film, whereby a uniform, large-area perovskite thin film can be manufactured without using an anti-solvent; a coating agent used in said method; and a perovskite solar cell including said perovskite thin film as a light absorption layer.

## Description

### TECHNICAL FIELD

The present invention relates to a method for forming a large-area perovskite thin film that can prepare a large-area uniform perovskite thin film without using an anti-solvent, a coating agent used therefor and a perovskite solar cell including the same as a light absorption layer.

### BACKGROUND ART

In order to solve global environmental problems caused by the depletion of fossil energy and the use thereof, research is being actively conducted on renewable and clean alternative energy sources such as solar energy, wind power and hydropower.

Among these, interest in solar cells, which change electrical energy directly from sunlight, is greatly increasing. Herein, a solar cell refers to a cell that generates current-voltage by absorbing light energy from sunlight and using the photoelectric effect to generate electrons and holes.

Currently, n-p diode-type silicon (Si) single crystal-based solar cells with a light energy conversion efficiency of over 20% can be manufactured and are used in actual solar power generation, and there are solar cells that use compound semiconductors such as gallium arsenide (GaAs) with even better conversion efficiency. However, these inorganic semiconductor-based solar cells require highly purified materials to achieve high efficiency, and thus, a lot of energy is consumed in purifying the raw materials, and expensive process equipment is required in the process of turning the raw materials into single crystals or thin films. However, there are limitations to lowering the manufacturing cost of solar cells, which has been an obstacle to the large-scale use thereof.

Accordingly, in order to manufacture solar cells at low cost, it is necessary to significantly reduce the cost of materials or manufacturing process used as the core of solar cells, and research is being conducted on perovskite solar cells that can be manufactured using low-cost materials and processes as an alternative to inorganic semiconductor-based solar cells.

The general structural formula of the perovskite structure is the AMX₃ structure, where an anion is located at the X site, a large cation is located at the A site, and a small cation is located at the M site.

These perovskite compounds have a wide range of applications due to their excellent electrical conductivity, charge mobility and optical properties, and have various features including a long lifespan, high absorption wavelength spectra due to small energy band gap, and wide charge-carrier diffusion length, while having the advantages of economical material price, solution production, low process cost and low-temperature process manufacturing. Therefore, they are attracting attention as a promising material for renewable energy applications, and particularly, research is ongoing to use the same as a light absorber for perovskite solar cells.

Currently, most perovskite thin films having a small area (approximately 2.5 × 2.5 cm²) are based on spin coating technology, and after uniformly applying a perovskite solution through spin coating, they is manufactured by a method of crystallization using an anti-solvent.

Since the spin coating method has limitations in large-area coating and mass production technology in principle, blades, slot dies, inkjet printing and spray coating are generally used to form thin films through large-area processes.

However, the existing perovskite thin films through the large-area coating have poor thin film uniformity and thermal stability, and since it performs an anti-solvent treatment process, there are limitations to the mass production of perovskite, such as the generation of waste due to the use of anti-solvents.

### DISCLOSURE

### TECHNICAL PROBLEM

The present invention has been devised to overcome the above-described problems, and is directed to providing a method for forming a large-area perovskite thin film with excellent uniformity by introducing a coating agent having an optimal composition for forming a large-area perovskite thin film without performing an anti-solvent treatment process, and a coating agent used therefor.

### TECHNICAL SOLUTION

In order to solve the above-described problems, the present invention relates to a coating agent for forming a large-area perovskite thin film, and the perovskite thin film includes a perovskite compound represented by Chemical Formula 1 below, and includes a perovskite precursor, a crystallinity enhancer, a Lewis base and a solvent.

[Chemical Formula 1] AₘA'₁₋ₘB(XₙX'₁₋ₙ)₃

In Chemical Formula 1, A is formamidinium (FA), ethylamine (EA), guanidinium (GA) or ethylenediamine (EDA), A' is Cs⁺, Na⁺, K⁺, NH₄⁺ or Rb⁺, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻ or I⁻, and m and n are rational numbers satisfying 0.7 ≤ m ≤ 0.9 and 0.1 ≤ n ≤0.3.

In a preferred embodiment of the present invention, the perovskite precursor may include an organic halide represented by Chemical Formula 2 below, a monovalent metal halide represented by Chemical Formula 3 below, a divalent metal halide represented by Chemical Formula 4 below and a divalent metal halide represented by Chemical Formula 5 below.

[Chemical Formula 2] AX

In Chemical Formula 2, A is formamidinium (FA), ethylamine (EA), guanidinium (GA) or ethylenediamine (EDA), and X is Br⁻ or I⁻.

[Chemical Formula 3] A'X

In Chemical Formula 3, A' is Cs⁺, Na⁺, K⁺, NH₄⁺ or Rb⁺, and X is Cl⁻, Br⁻ or I⁻.

[Chemical Formula 4] BX₂

[Chemical Formula 5] BX'₂

In Chemical Formula 4 and Chemical Formula 5, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻ or I⁻, and X and X' are different halogen anions.

In a preferred embodiment of the present invention, the crystallization enhancer may include at least one selected from CH₃NH₃Cl, CH₃NH₃Br and CH₃NH₃I.

In a preferred embodiment of the present invention, the Lewis base may include at least one selected from N,N-dimethyl-propyleneurea (DMPU), hexamethylphosphoramide (HMPA) and N-methyl-2-pyrrolidone (NMP).

In a preferred embodiment of the present invention, the solvent may include at least one selected from dimethylformamide (DMF), γ-butyrolactone, 2-methoxyethanol, dimethyl sulfoxide (DMSO) and N-methyl-2-pyrrolidinone (NMP).

In a preferred embodiment of the present invention, the coating agent may include 15 to 30 mol% of the crystallinity enhancer and 40 to 100 mol% of the Lewis base based on 100 mol% of the perovskite precursor.

In a preferred embodiment of the present invention, the coating agent may include the solvent and the Lewis base in a volume ratio of 1:0.06 to 0.25.

Another object of the present invention relates to a method for forming a large-area (an area of 200 cm² or more) perovskite thin film, and it may perform a process including step 1 of preparing a coating agent for forming a perovskite thin film; step 2 of performing a coating process and drying the coating agent on an upper part of a substrate to form a wet-thin film including a perovskite crystallized in an intermediate phase; and step 3 of performing an annealing process on the wet-thin film to form a large-area perovskite thin film including a perovskite compound represented by Chemical Formula 1 below.

In a preferred embodiment of the present invention, the upper part of the substrate on which the coating agent is coated may be a Si thin film layer, a hole transport layer, an electron transport layer or a passivation layer.

In a preferred embodiment of the present invention, the coating process may be performed by blade coating, slot die coating, bar coating, inkjet coating or spray coating.

In a preferred embodiment of the present invention, the drying may be performed together with the coating process, or after the coating process is completed.

In a preferred embodiment of the present invention, the drying may be performed by a knife blowing process to evaporate a solvent.

In a preferred embodiment of the present invention, the drying may be performed by an inert gas drying process such as N₂ or Ar, or a knife blowing process using an air knife to evaporate the solvent of the coating agent.

In a preferred embodiment of the present invention, the annealing may be performed by heat treatment at 120 to 180°C for 5 to 20 minutes.

Still another object of the present invention relates to a perovskite solar cell including the perovskite thin film formed by the above method using the coating agent as a light absorption layer (or photoactive layer).

In a preferred embodiment of the present invention, the perovskite solar cell may be a tandem solar cell.

In a preferred embodiment of the present invention, it may be a tandem solar cell including an upper cell including a perovskite thin film formed with the coating agent for forming a large-area perovskite thin film described above as a light absorption layer; and a lower cell including Si, Cu(In,Ga)Se₃, CdTe or a perovskite compound as a light absorption layer.

### ADVANTAGEOUS EFFECTS

The method of forming a perovskite thin film using the coating agent of the present invention does not perform an anti-solvent treatment process, and thus, it is environmentally friendly and has excellent mass productivity. In addition, the perovskite thin film prepared by using the coating agent and forming method of the present invention has excellent uniformity and thermal stability, and by introducing the same into the light absorption layer of a solar cell, it is possible to manufacture a perovskite solar cell with high energy conversion efficiency.

### DESCRIPTION OF DRAWINGS

FIG. 1 shows the results of PL mapping measurements performed in Experimental Example 1.
FIGS. 2a to 2c are SEM measurement images performed in Experimental Example 2.
FIG. 3 shows the results of UV-Vis and XRD measurements performed in Experimental Example 3.
FIG. 4 is a set of side SEM measurement images to determine the state of perovskite thin film formation according to the mol% of Lewis base in Examples 2 to 5, Comparative Examples 1 and Comparative Examples 3.
FIG. 5 is a set of performance measurement graphs of a single solar cell device according to the content of the crystallinity enhancer performed in Experimental Example 5.
FIGS. 6a and 6b are performance measurement graphs for a single solar cell device performed in Experimental Example 6.
FIG. 7 is a performance measurement graph for a solar cell tandem device performed in Experimental Example 6.

### MODES OF THE INVENTION

Hereinafter, the present invention will be described in more detail through a method for forming a large-area perovskite thin film. Herein, the large area means an area of 200 cm² or more, and preferably, 250 cm² or more.

The present invention may perform a process including step 1 of preparing a coating agent for forming a perovskite thin film; step 2 of performing a coating process and drying the coating agent on an upper part of a substrate to form a wet-thin film including a perovskite crystallized in an intermediate phase; and step 3 of performing an annealing process on the wet-thin film to form a large-area perovskite thin film including a perovskite compound represented by Chemical Formula 1 below, so as to form and obtain a large-area perovskite thin film.

[Formula 1] AₘA'₁₋ₘB(XₙX'₁₋ₙ)₃

In Chemical Formula 1, A is formamidinium (FA), ethylamine (EA), guanidinium (GA) or ethylenediamine (EDA), preferably, FA, GA or EDA, and more preferably, FA. In addition, A' in Chemical Formula 1 is Cs⁺, Na⁺, K⁺, NH₄⁺ or Rb⁺, preferably, Cs⁺, Na⁺ or K⁺, and more preferably, Cs⁺.

B in Chemical Formula 1 is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, preferably, Pb²⁺, Sn²⁺, Pd²⁺ or Cu²⁺, and more preferably, Pb²⁺ or Sn²⁺.

Additionally, X and X' in Chemical Formula 1 are each independently Cl⁻, Br⁻ or I⁻, and preferably, X is I⁻ and X' is Br⁻. In addition, m and n in Chemical Formula 1 are rational numbers satisfying 0 < m ≤ 1 and 0 < n ≤ 1, and are preferably rational numbers satisfying 0.7 ≤ m ≤ 0.9 and 0.1 ≤ n ≤ 0.3.

Typically, the AₘA'₁₋ₘ site is formed by mixing a monovalent organic cation with a monovalent inorganic cation to form a monovalent cation. Specifically, in Chemical Formula 1, A may include amines, ammonium, Group 1 metals, Group 2 metals and/or other cations or cation-like compounds, such as formamidinium (hereinafter, "FA"), methylammonium (hereinafter, "MA") and FAMA.

MA-based perovskites, in which MA makes up most of the composition ratio, may be coated without anti-solvents and are suitable for mass production, but they have the fatal problem of not being able to secure thermal stability.

Meanwhile, FA-based perovskite, which is currently recording the highest efficiency, has low phase stability, and thus, anti-solvent free processes are limited, and uniform large-area thin film coating is difficult.

According to one embodiment of the present invention, in the structure of AₘA'₁₋ₘB(XₙX'₁₋ₙ)₃, the inventors of the present invention attempted to solve the phase stability issue of FA-based perovskite by optimizing the mixing composition. Specifically, the present invention sought to secure phase stability by stabilizing the crystal structure without reducing the thermal stability of the perovskite by introducing a small amount of Group 1 metal cations into the MA Free-based metal halide perovskite.

For the above-described effects, the composition (1-m) of the Group 1 metal cation may be controlled to 0.1 or more, and considering the band gap of the tandem device, the composition (1-m) of the metal cation may be controlled to 0.3 or less. Accordingly, the band gap of the perovskite material may be 1.50 eV to 1.80 eV, and preferably, 1.55 eV to 1.72 eV.

The coating agent for forming a perovskite thin film of the present invention includes a perovskite precursor, a crystallinity enhancer, a Lewis base and a solvent.

In the composition of the coating agent, the perovskite precursor includes an organic halide represented by Chemical Formula 2 below, a monovalent metal halide represented by Chemical Formula 3 below, a divalent metal halide represented by Chemical Formula 4 below (a first divalent metal halide) and a divalent metal halide (a second divalent metal halide) represented by Chemical Formula 5 below.

[Chemical Formula 2] AX

In Chemical Formula 2, A is formamidinium (FA), ethylamine (EA), guanidinium (GA) or ethylenediamine (EDA), preferably FA, GA or EDA, and more preferably FA. In addition, X in Chemical Formula 2 is Br⁻ or I⁻.

[Chemical Formula 3] A'X

In Chemical Formula 3, A' is Cs⁺, Na⁺, K⁺, NH₄⁺ or Rb⁺, preferably, Cs⁺, Na⁺ or K⁺, and more preferably, Cs⁺. In addition, X in Chemical Formula 3 is Br⁻ or I⁻.

[Chemical Formula 4] BX₂

[Chemical Formula 5] BX'₂

In Chemical Formula 4 and Chemical Formula 5, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, preferably Pb²⁺, Sn²⁺, Pd²⁺ or Cu²⁺, and more preferably, Pb²⁺ or Sn²⁺. In addition, X of Chemical Formula 4 and X' of Chemical Formula 5 are each independently Cl⁻, Br⁻ or I⁻, and preferably, Br⁻ or I⁻, and X and X' are different halogen anions.

The crystallinity enhancer in the perovskite coating agent composition serves to increase the phase stability of a perovskite and improve crystallinity by increasing the perovskite crystal particle size, and the coating agent may include 15 to 40 mol% of the crystallinity enhancer, and preferably, 15.5 to 25.0 mol% of the crystallinity enhancer, based on 100 mol% of the perovskite precursor.

In this case, if the crystallinity enhancer is included at less than 15 mol%, there may be a problem in that the perovskite crystals do not crystallize to a sufficient size. If it exceeds 40 mol%, the crystals may not be formed evenly due to excessive use, and the perovskite crystals may not be crystallized to a sufficient size, and there may be a problem in that the surface of the perovskite thin film is not formed uniformly.

The crystallinity enhancer may include at least one selected from CH₃NH₃Cl (MACl), CH₃NH₃Br (MABr) and CH₃NH₃I (MAI), preferably, it may include at least one selected from MACl and MABr, and it may preferably include MACl.

The crystallinity enhancer is decomposed and removed during step 3 of annealing of the thin film formation process. For example, MACl is removed in the form of MA gas and HCl during the annealing process, and thus, it does not remain in the perovskite crystal.

Among the perovskite coating composition in step 1, the Lewis base serves to increase the phase stability of the perovskite and prevent the formation of pinholes in the thin film, and a polar aprotic compound may be used, and it may preferably include at least one selected from N,N-dimethyl-propyleneurea (DMPU), hexamethylphosphoramide (HMPA) and N-methyl-2-pyrrolidone (NMP), and preferably, it may include DMPU.

The Lewis base is preferably included in an amount of 40 to 100 mol%, preferably 40 to 90 mol%, and more preferably 50 to 85 mol%, based on 100 mol% of the perovskite precursor in the coating agent. In this case, if the content of the Lewis base is less than 40 mol%, the binding energy of the perovskite crystal intermediate phase in the wet-thin film formed through drying in the thin film formation process is weak, and thus, the perovskite crystal phase may not be formed well, and the uniformity of the thin film may not be good. In addition, if it exceeds 100 mol%, perovskite crystallization may not be smooth due to supersaturation, which may lead to a problem of the formation of a non-uniform thin film. Therefore, in the present invention, the content of the Lewis base in the coating agent was controlled within the above range.

The solvent in the perovskite coating agent composition may include at least one selected from dimethylformamide (DMF), gamma-butyrolactone (γ-butyrolactone), 2-methoxyethanol, dimethyl sulfoxide (DMSO) and N-methyl-2 - pyrrolidinone (NMP), and preferably, it may include at least one selected from DMF, gamma-butyrolactone and 2-methoxyethanol, more preferably, it may include DMF.

In addition, for the amount of solvent used in the coating agent, it is preferable to use the solvent and the Lewis base in a volume ratio of 1:0.06 to 0.25, preferably the solvent and the Lewis salt in a volume ratio of 1:0.10 to 0.22, and more preferably the solvent and the Lewis salt in a volume ratio of 1:0.10 to 0.18. If the solvent content compared to the Lewis base is too excessive, pinholes may occur in the thin film, and if the solvent content compared to the Lewis base is too small, coating properties may not be secured, and there may be a problem in that surface roughness decrease significantly. Therefore, in the present invention, the solvent content in the coating agent was controlled within the above range.

Next, the description of step 2 of the method for forming a large-area perovskite thin film according to the present invention refers to an object on which the coating solution of step 1 is coated, and the coating solution may be coated on the top of the Si thin film, the top of the hole transport layer, the top of the electron transport layer or the top of the passivation layer.

In addition, the coating process of step 2 may be performed by blade coating, slot die coating, bar coating, inkjet coating or spray coating, and preferably, it may be performed by blade coating, slot die coating or bar coating.

In addition, the drying of step 2 may be performed together with the coating process, or may be performed as a separate process after the coating process is completed. Preferred examples of drying methods include inert gas drying such as N₂ or Ar, or air knife drying, and drying may be performed using an air knife, and through drying, the solvent in the coating may be evaporated, and a wet-thin film including crystallized perovskite as an intermediate phase is formed.

Next, the annealing of step 3 of the method for forming a large-area perovskite thin film according to the present invention may be performed by heat treatment at 120 to 180°C for 5 to 20 minutes, and preferably, heat treatment may be performed at 130 to 160°C for 7 to 15 minutes. During the annealing process, the crystallinity enhancer is removed by vaporization or the like, as described above. For example, a perovskite thin film is formed through reactions shown in Reaction Schemes 1 to 5 below, and the crystallinity enhancer may be removed by evaporation.

[Reaction Schemes] 1. PbCl₂ + FAI + 2MAI → FAPbl₃ + MACI (evaporation removal) 2. PbI₂ + FAI + MACl → FAPbl₃ + MACI (evaporation removal) 3. PbI₂ + FABr + MACl → FAPbl₂Br + MACI (evaporation removal) 4. PbCl₂ + FABr + 2MABr → FAPbBr₃ + MACI (evaporation removal) 5. PbBr₂ + FABr + 2MAI → FAPbBr₃ + MAI (evaporation removal)

By performing steps 1 to 3 described above, a uniform, large-area thin film with excellent thermal stability including a perovskite compound represented by Chemical Formula 1 above may be prepared through a mass production process.

The present invention may provide a perovskite solar cell with excellent power conversion efficiency (PCE) by forming a light absorption layer of a solar cell using the coating agent and method for forming a perovskite thin film described above. The solar cell of the present invention may be a fin structure-type perovskite solar cell, an inverted-structure perovskite solar cell, a tandem-type perovskite solar cell or a tandem-type silicon/perovskite heterojunction solar cell.

For example, in a tandem solar cell composed of a silicon lower cell and a perovskite upper cell, a perovskite light absorption layer may be formed on the upper cell using the coating agent and method of the present invention.

Additionally, in a tandem solar cell consisting of a lower cell including Cu(In,Ga)Se₃, CdTe or a perovskite compound as a light absorption layer, and a perovskite upper cell, the light absorption layer of the upper cell may also be formed as a perovskite light absorption layer using the coating agent and method of the present invention.

The recombination layer is a layer that induces the recombination of electrons and holes generated in the lower cell and the light absorption layer to be described below, and it may be a transparent thin film on which ITO (Induim Tin Oxide), FTO (Fluorine doped Tin Oxide), ATO (Sb₂O₃ doped Tin Oxide), GTO (Gallium doped Tin Oxide), ZTO (tin doped zinc oxide), ZTO:Ga (gallium doped ZTO), IGZO (Indium gallium zinc oxide, IZO (Indium doped zinc oxide) or AZO (Aluminum doped zinc oxide) is deposited

In addition, as an example of forming a recombination layer, when using a silicon solar cell doped with n- or p-type impurities as a lower cell, the silicon solar cell doped with n- or p-type impurities may be treated with hydrofluoric acid to remove a SiOx oxide film and then washed with ultrapure water to remove residual hydrofluoric acid, and a recombination layer may be formed on the top of the silicon solar cell from which the oxide film has been removed through a sputtering process.

The hole transport layer (HTL) may include inorganic and/or organic hole transport materials. The inorganic hole transport material may include at least one selected from nickel oxide (NiOₓ), CuSCN, CuCrO₂and CuI.

The organic hole transport material may include carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives., aromatic tertiary amine compounds, styrylamine compounds, aromatic dimethylidine compounds, porphyrin compounds, phthalocyanine compounds, polythiophene derivatives, polypyrrole derivatives, polyparaphenylenevinylene derivatives, pentacene, coumarin 6(coumarin 6, 3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride), N3 (cis-di(thiocyanato)-bis(2,2'-bipyridyl-4,4'-dicarboxylic acid) )-ruthenium(II), P3HT (poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2"-ethylhexyloxy)-p-phenylene vinylene]), P3OT (poly(3-octyl thiophene)), POT (poly(octyl thiophene)), P3DT (poly(3-octyl thiophene)), P3DDT (poly(3-dodecyl thiophene)), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-di-pmethoxyphenyl amine)-9,9,9'-spirobi fluorine]), CuSCN, CuI, PCPDTBT (Poly[2,1,3-benzothiadiazole-4,7-diyl[4,4-bis(2-ethylhexyl-4H-cyclopenta [2,1-b:3,4-b']dithiophene-2,6- diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl- fluorene)-alt-5,5-(4',7,-di-2-thienyl-2',1', 3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly[[9-(1 -octylnonyl)-9H-carbazole-2,7-diyl]-2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz and/or MeO-2PACz.

In addition, methods for forming a hole transport layer may include coating and vacuum deposition methods, and the coating methods may include gravure coating, bar coating, printing, spraying, spin coating, dip and die coating methods.

Next, the light absorption layer is a large-area thin film layer formed through the coating agent and method of the present invention described above, and it may include a perovskite crystal represented by Chemical Formula 1 above.

Meanwhile, a protective layer (not shown) may be further included between the hole transport layer and the light absorption layer. Specifically, the protective layer may include a material having a carbazole body with strong hole collecting ability and a phosphonic acid group with strong bonding force with metal oxide, and preferably, it may include SAM materials such as 2-PACz, MeO-2PACz, Br-2PACz, Me-4PACz, MeO-4PACz, 6-PACz and the like.

Methods for forming a protective layer may include coating and/or vacuum deposition, and the coating methods may include gravure coating, bar coating, printing, spraying, spin coating, blade coating, dip coating and die coating methods, and preferably, a protective layer may be formed on one surface of the hole transport layer through a vacuum deposition method.

Next, the electron transport layer may include an inorganic material (e.g., a metal oxide) and/or an organic material. The electron transport layer may be a flat metal oxide layer, a metal oxide layer having surface roughness, a composite metal oxide layer having nanostructures of the same or different metal oxides (including metal oxide particles, nanowires and/or nanotubes) formed on the surface of a thin film-shaped metal oxide, or a porous metal oxide layer, and it may preferably include a compact metal oxide layer and a meso-porous metal oxide layer. Preferred examples may include SnO₂, TiO₂, ZnO and the like. Additionally, the organic material may include PCBM.

Meanwhile, a buffer layer may be further included between the electron transport layer and the light absorption layer. The buffer layer is a layer formed to prevent interfacial defects and improve transport capacity, and it may include at least one selected from C60, PCBM and PC71BM.

Methods for forming a buffer layer may include coating and/or vacuum deposition, and the coating methods may include gravure coating, bar coating, printing, spraying, spin coating, blade coating, dip and die coating, and according to one embodiment, a protective layer may be formed on one surface of the light absorption layer through a vacuum deposition method.

Additionally, in the solar cell composition, the upper electrode (or source electrode) may be formed by coating with or depositing at least one material selected from Pt, Au, Ni, Cu, Ag, In, Ru, Pd, Rh, Ir, Os, C and conductive polymers.

In addition, the solar cell may further include a passivation layer between the light absorption layer and the electron transport layer.

Hereinafter, the present invention will be described in more detail through examples. However, the following examples do not limit the scope of the present invention, and should be interpreted to aid understanding of the present invention.

### [Example]

### Example 1: Preparation of perovskite coating agent and perovskite thin film

After adding DMF as a solvent to an Erlenmeyer flask, a perovskite precursor was added and stirred to dissolve the same.

In this case, the perovskite precursor was composed of FAI powder (organic halide), CsBr powder (metal halide), PbI₂ powder and PbBr₂ powder at a molar ratio of 1 : 1 : 0.25 : 0.25.

Then, 25 mol% of CH₃NH₃Cl (crystallinity enhancer) and 50 mol% of DMPU (N,N-dimethyl-propyleneurea, Lewis base) were added based on 100 mol% of the perovskite precursor and stirred to prepare a coating agent for forming a thin film.

Next, the coating agent was blade coated on the top of one surface of an ITO glass substrate having a size of 16 × 16 cm² using a blade coater, and then, N₂ was blown using an air knife to dry the coating agent to form a wet-thin film including perovskite that was crystallized into an intermediate phase.

Next, the glass substrate on which the wet-thin film was formed was annealed at 150°C for 10 minutes to form a perovskite thin film including a perovskite compound represented by Chemical Formula 1-1 below with a thickness of 550 nm.

[Chemical Formula 1-1] AₘA'₁₋ₘB(XₙX'₁₋ₙ)₃

In Chemical Formula 1-1, A is formamidinium (FA), A' is Cs⁺, B is Pb²⁺, X is I⁻, X' is Br⁻, and m= 0.8, n= 0.8.

### Comparative Example 1

A perovskite coating agent and a perovskite thin film using the same were formed on the glass substrate by the same method as in Example 1, except that no Lewis base was used in preparing the coating agent.

### Comparative Example 2

A perovskite coating agent and a perovskite thin film using the same were formed on the glass substrate by the same method as in Example 1, except that as a Lewis base during the preparation of the coating agent, instead of DMPU, 50 mol% of dimethyl sulfoxide (DMSO), which is currently the substance with the highest efficiency in spin coating, was used.

**[Table 1]**

| Classification | Perovskite Precursor | Crystallinity Enhancer | Lewis Base | |
|---|---|---|---|---|
| | | | Type | Used Amount |
| Example 1 | 100 mol% | 25 mol% | DMPU | 50 mol% |
| Comparative Example 1 | 100 mol% | 25 mol% | - | - |
| Comparative Example 2 | 100 mol% | 25 mol% | DMSO | 50 mol% |

### Experimental Example 1: PL mapping (Micro Photoluminescence mapping) measurement

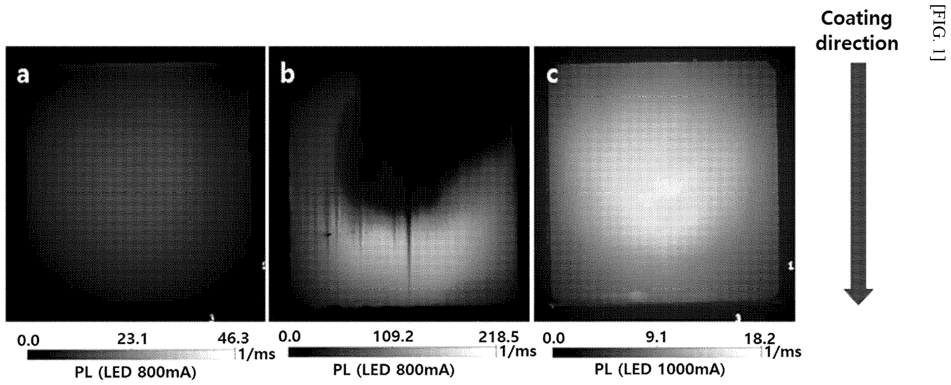

PL mapping of the perovskite thin films prepared in Example 1 and Comparative Examples 1 and 2 was performed, and the results are shown in FIG. 1.

In FIG. 1, a is a measurement image of the thin film surface of Comparative Example 1, b is a measurement image of the thin film surface of Comparative Example 2, and c is a measurement image of the thin film surface of Example 1. In the case of Comparative Example 1, the thin film surface appears uniform, but overall, the perovskite film was not formed and instead appears uniform.

In the case of Comparative Example 2, It was confirmed that there was a problem in that there were areas where perovskite was well formed locally and coated (light-colored areas) and areas where perovskite was not well formed and coated (black areas). On the other hand, in Example 1, it was confirmed that a perovskite thin film with an overall uniform surface was formed.

### Experimental Example 2: SEM (scanning electron microscope) measurement

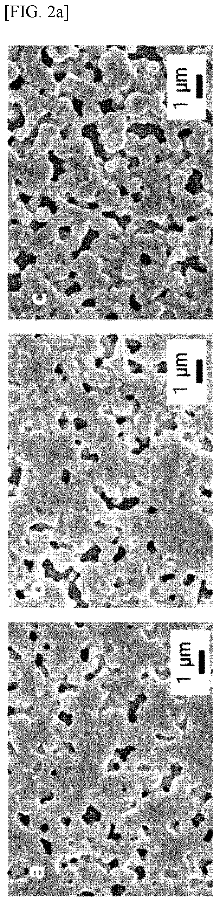

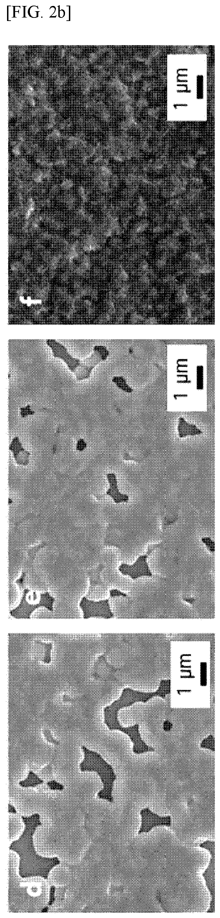

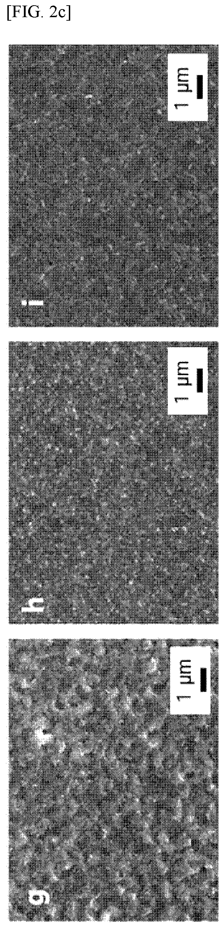

SEM measurements were performed on each of the perovskite thin films prepared in Example 1 and Comparative Examples 1 and 2, and the results are shown in FIGS. 2a (Comparative Example 1), FIG. 2b (Comparative Example 2) and FIG. 2c (Example 1).

Referring to FIG. 2a, in the case of the large-area perovskite thin film of Comparative Example 1 prepared without using a Lewis base, it was confirmed that there was a problem in securing coverage over the entire area due to the formation of a large amount of pinholes.

In addition, referring to FIG. 2b, the large-area perovskite thin film of Comparative Example 2 using DMSO as a Lewis base had a portion (f) where an excellent thin film is formed, but, like Comparative Example 1, there was a problem in that a large amount of pinholes were generated and the thin film was not formed (d,e).

On the other hand, referring to g, h and i of FIG. 2c, the large-area perovskite thin film of Example 1 had excellent thin film uniformity overall and did not generate pinholes. This is because the thin film was coated evenly by DMPU (Lewis base), which has a strong bonding energy with the perovskite precursor, and the perovskite crystallinity and bonding strength were improved, and thus, even when large-area coating was performed, it was confirmed that pinholes were not formed, and it was possible to form a uniform thin film.

### Experimental Example 3: UV-Vis (Ultraviolet-visible spectroscopy) and XRD (X-ray diffraction) measurements

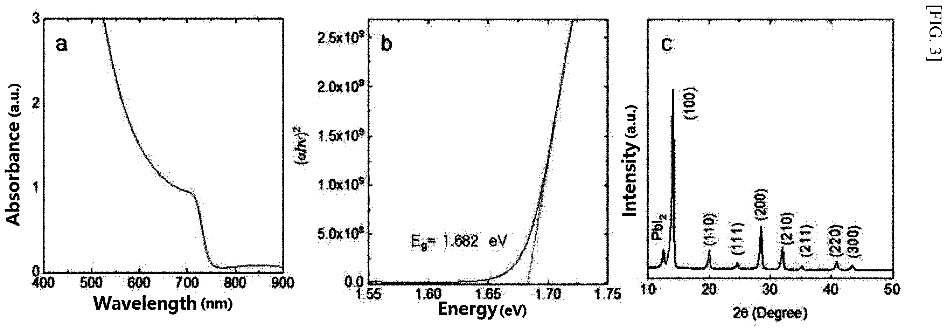

UV-Vis measurements were performed on the perovskite thin film prepared in Example 1, and the results are shown in FIGS. 3a (absorbance) and FIG. 3b (energy band gap).

The energy band gap was calculated based on absorbance measurements.

The energy band gap (E_{g}) was 1.682 eV, which is a numerical value that satisfies the energy band gap (1.5 eV ≤ E_{g} ≤ 1.8 eV) required for the perovskite light absorption layer for the upper cell device of a tandem silicon/perovskite heterojunction solar cell.

Additionally, XRD measurement was performed on the perovskite thin film prepared in Example 1, and the results are shown in FIG. 3c. As a result of XRD measurement, it was confirmed that cubic-phase perovskite crystals were well formed in the thin film.

### Examples 2 to 5 and Comparative Example 3

A perovskite coating agent and a perovskite thin film using the same were formed on the glass substrate by the same method as in Example 1, except that as shown in Table 2 below, Example 2 used 40 mol% of DMPU, which is a Lewis base, Example 3 used 60 mol% of DMPU, Example 4 used 80 mol% of DMPU, and Example 5 used 100 mol% of DMPU during the preparation of the coating agent. In addition, Comparative Example 3 used 20 mol% of DMPU.

**[Table 2]**

| Classification | Perovskite Precursor | Crystallinity Enhancer | Lewis Base | |
|---|---|---|---|---|
| | | | Type | Used Amount |
| Example 2 | 100 mol% | 25 mol% | DMPU | 40 mol% |
| Example 3 | 100 mol% | 25 mol% | DMPU | 60 mol% |
| Example 4 | 100 mol% | 25 mol% | DMPU | 80 mol% |
| Example 5 | 100 mol% | 25 mol% | DMPU | 100 mol% |
| Comparative Example 1 | 100 mol% | 25 mol% | - | - |
| Comparative Example 3 | 100 mol% | 25 mol% | DMPU | 20 mol% |

### Experimental Example 4: SEM (scanning electron microscope) measurement

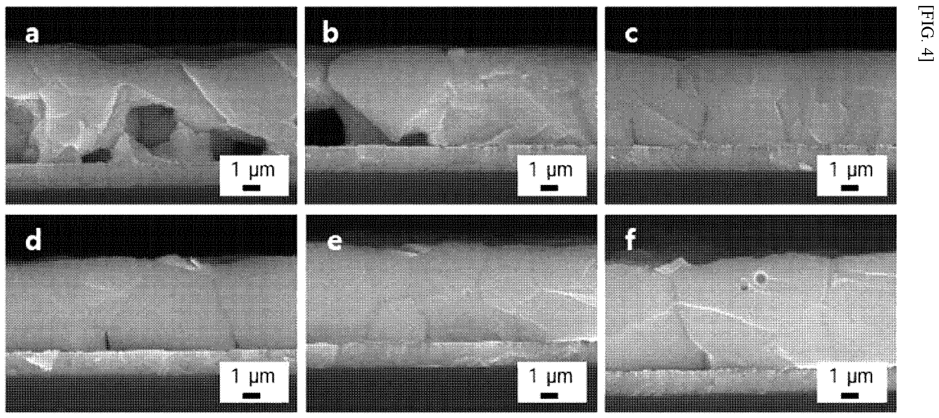

In order to confirm the state of perovskite thin film formation according to the Lewis base mol%, SEM measurements were performed on the cross-sections of the thin films prepared in Examples 2 to 5 and Comparative Examples 1 and 3, and the image measurement results are shown in a to f of FIG. 4.

### (a: Comparative Example 1, b: Comparative Example 3, c: Example 2, d: Example 3, e: Example 4, f: Example 5)

Looking at FIG. 4, it could be confirmed that in Comparative Example 1 (0 mol%) and Comparative Example 3 (20 mol%) where the DMPU content, which is a Lewis base, was used at less than 40 mol%, cave-shaped pinholes were present, and the thin films were formed non-uniformly. On the other hand, it was confirmed that in Examples 2 to 5 where the DMPU content was 40 to 100 mol%, no pinholes were present, and uniform thin films were formed.

### Examples 6 to 8 and Comparative Example 4: Preparation of perovskite thin films according to crystallinity enhancer content

Perovskite coating agents and perovskite thin films using the same were formed on the glass substrate by the same method as in Example 1, except that as shown in Table 3 below, Examples 6, 7 and 8 used 30, 20 and 15 mol% of CH₃NH₃Cl which is a crystallinity enhancer, and Comparative Example 4 used 10 mol% of CH₃NH₃Cl which is a crystallinity enhancer to prepare perovskite thin films, respectively.

**[Table 3]**

| Classification | Perovskite Precursor | Crystallinity Enhancer | Lewis Base | |
|---|---|---|---|---|
| | | | Type | Used amount |
| Example 6 | 100 mol% | 30 mol% | DMPU | 50 mol% |
| Example 7 | 100 mol% | 20 mol% | DMPU | 50 mol% |
| Example 8 | 100 mol% | 15 mol% | DMPU | 50 mol% |
| Comparative Example 4 | 100 mol% | 10 mol% | DMPU | 50 mol% |

### Experimental Example 5: Performance measurement of solar cell devices

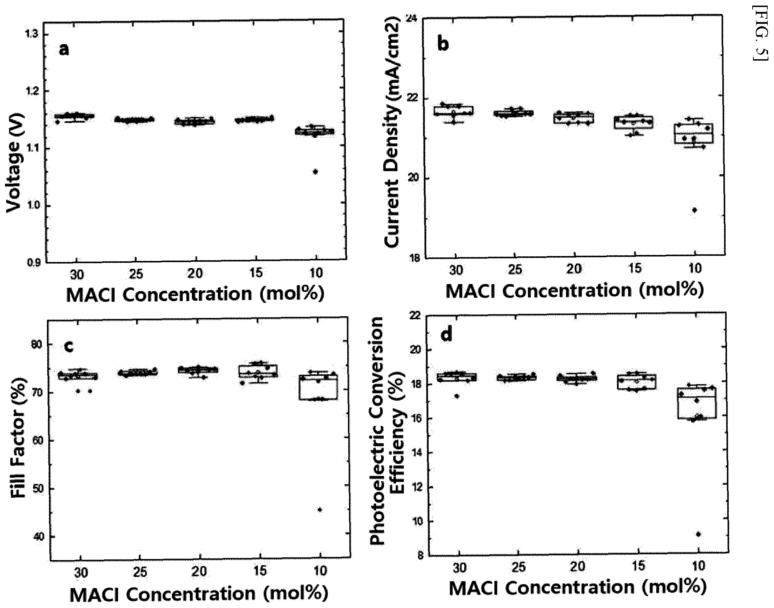

An opaque device was manufactured by varying the content of MACl, which is a crystallinity enhancer, in a range of 30 to 10 mol%, and IV measurements were performed, and the results are shown in Table 4 and FIG. 5. Referring to Table 4 and FIG. 5 below, the average efficiency was generally similar from 15 to 30 mol% in Examples 6 to 8, and the smallest deviation was confirmed to be 18.35% at 25 mol%. Since this plays a role in helping particle growth, which is the role of a generally known crystallinity enhancer, it can be said that the perovskite characteristics are dense and large particles are formed. On the other hand, in the case of Comparative Example 4 in which the content of the crystallinity enhancer was less than 15 mol%, terminal characteristics (Voc, Jsc, FF) were not secured, and it can be confirmed that the final conversion efficiency did not reach those of Examples 1 and 6 to 8.

**[Table 4]**

| Classification | Type of Coating Solution | Crystallinit y Enhancer (mol%) | Open-circuit Voltage (V_{oc}, V) | Short-circuit Current Density (J_{sc}, mA/cm²) | Fill Factor (FF,%) | Photoelectric Conversion Efficiency (%) |
|---|---|---|---|---|---|---|
| Manufacture Example 1 | Example 6 | 30 | 1.155 ± 0.004 | 21.65 ± 0.15 | 73.30 ± 1.34 | 18.34 ± 0.45 |
| Manufacture Example 1 | Example 1 | 25 | 1.148 ± 0.002 | 21.60 ± 0.07 | 73.98 ± 0.41 | 18.35 ± 0.12 |
| Manufacture Example 1 | Example 7 | 20 | 1.144 ± 0.004 | 21.47 ± 0.11 | 74.31 ± 0.72 | 18.25 ± 0.19 |
| Manufacture Example 1 | Example 8 | 15 | 1.146 ± 0.002 | 21.33 ± 0.18 | 73.85 ± 1.44 | 18.06 ± 0.41 |
| Manufacture Example 1 | Comparati ve Example 4 | 10 | 1.117 ± 0.026 | 20.86 ± 0.74 | 68.16 ± 9.60 | 16.00 ± 2.89 |

### Manufacture Example 1-1: Manufacture of perovskite solar cell

A single opaque perovskite solar cell device was manufactured using the coating agent for forming a perovskite thin film prepared in Example 1 (Active area: 0.096 cm²). Specifically, the structure of the single opaque device was as follows: NiOx (17 nm), 2PACz (1 nm), a perovskite thin film (550 nm), LiF (1 nm), C60 (13 nm), BCP (8 nm) and a Ag electrode (200 nm) on an organic substrate deposited with ITO (100 nm).

### Manufacture Example 1-2: Manufacture of perovskite solar cell

A single perovskite solar cell device was manufactured in the same manner as Manufacture Example 1, except that the coating agents of Examples 2 to 5, Comparative Example 1 and Comparative Example 3 were used instead of Example 1 to manufacture single opaque perovskite solar cell devices (Active area: 0.096 cm²), so as to perform Manufacture Examples 1-2 to 1-5, Comparative Manufacture Example 1-1 and Comparative Manufacture Example 1-2, respectively (see Table 5 below).

### Manufacture Example 2: Manufacture of tandem silicon/perovskite heterojunction solar cell

A silicon/perovskite heterojunction solar cell tandem device was manufactured using the coating agent for forming a perovskite thin film prepared in Example 1 (Active area: 242.74 cm²). The structure of the manufactured tandem device was as follows: ITO (20 nm)/NiOx (17 nm)/2PACz (1 nm), and a perovskite film (550 nm)/LiF (1 nm)/C60 (13 nm)/SnOx (6 nm)/ITO (50 nm)/Ag (200 nm) on a Si sub-device.

### Experimental Example 6: Performance measurement of solar cell devices

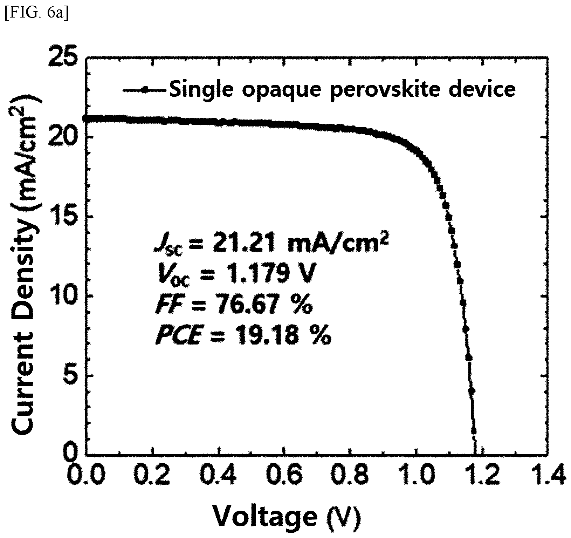

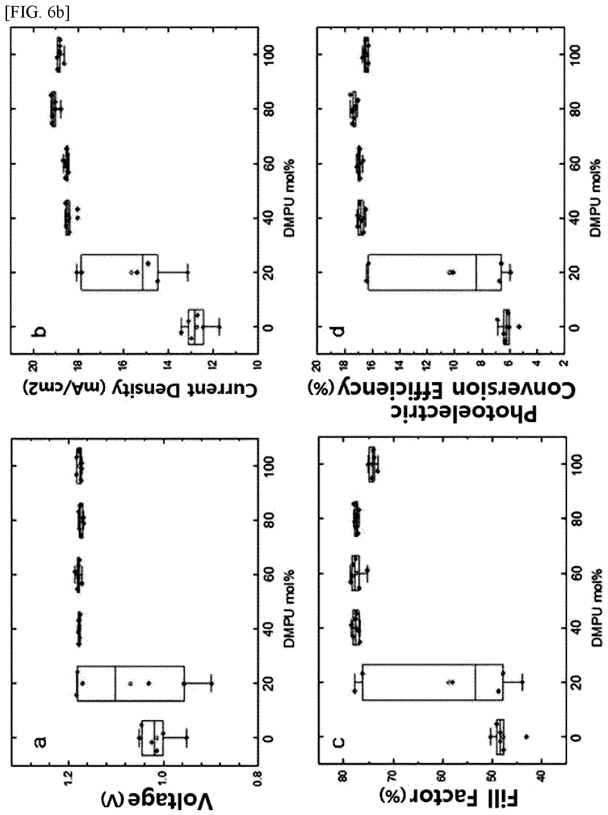

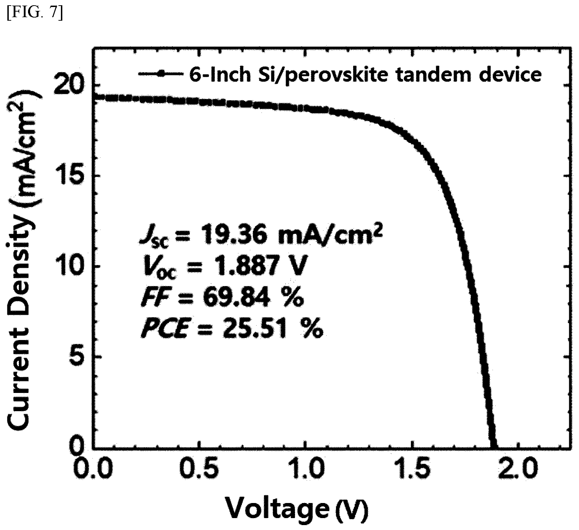

The current-voltage characteristics and efficiency of the solar cells manufactured in Manufacture Examples 1-1 to 1-5, Comparative Manufacture Examples 1-1 to 1-2 and Manufacture Example 2 were measured, and the results are shown in Tables 5 and 6 below. In addition, performance measurement graphs are shown in FIG. 6a (single device, Manufacture Example 1-1), FIG. 6b (single device, Manufacture Examples 1-2 to 1-5, Comparative Manufacture Examples 1-1 to 1-2) and FIG. 7 (tandem device).

**[Table 5]**

| Classification | Type of Coating Solution | DMPU (mol%) | Open-circuit Voltage (V_{oc}, V) | Short-circuit Current Density (J_{sc}, mA/cm²) | Fill Factor (FF,%) | Photoelectric Conversion Efficiency (%) |
|---|---|---|---|---|---|---|
| Manufacture Example 1-1 | Example 1 | 50 | 1.179 | 21.21 | 76.67 | 19.18 |
| Manufacture Example 2 | Example 1 | 50 | 1.887 | 19.36 | 69.84 | 25.51 |

**[Table 6]**

| Classification | Type of Coating Solution | DMPU mol% | Open-circuit Voltage (V_{oc}, V) | Short-circuit Current Density (J_{sc}, mA/cm²) | Fill Factor (FF,%) | Photoelectric Conversion Efficiency (%) |
|---|---|---|---|---|---|---|
| Manufacture Example 1-2 | Example 2 | 40 | 1.178 ± 0.002 | 18.41 ± 0.20 | 77.54 ± 0.63 | 16.81 ± 0.22 |
| Manufacture Example 1-3 | Example 3 | 60 | 1.180 ± 0.005 | 18.54 ± 0.07 | 77.45 ± 1.21 | 16.93 ± 0.16 |
| Manufacture Example 1-4 | Example 4 | 80 | 1.174 ± 0.004 | 19.07 ± 0.16 | 77.43 ± 0.40 | 17.34 ± 0.19 |
| Manufacture Example 1-5 | Example 5 | 100 | 1.177 ± 0.005 | 18.83 ± 0.11 | 74.29 ± 0.72 | 16.47 ± 0.16 |
| Comparative Manufacture Example 1-1 | Example 1 | 0 | 1.015 ± 0.036 | 12.72 ± 0.59 | 47.84 ± 2.50 | 6.18 ± 0.53 |
| Comparative Manufacture Example 1-2 | Example 1 | 20 | 1.070 ± 0.126 | 15.64 ± 1.95 | 58.73 ± 14.88 | 10.36 ± 4.87 |

Looking at Tables 5 and 6 above, Comparative Manufacture Example 1-1 and Comparative Manufacture Example 1-2, in which a perovskite coating layer using less than 40 mol% of DMPU, which is a Lewis base, was introduced as a light absorption layer, had photoelectric conversion efficiencies of less than 10.50%. When compared to Manufacture Examples 1-1 to 1-5, it was confirmed that they had relatively very low photoelectric conversion efficiencies.

On the other hand, it was confirmed that Manufacture Examples 1-1 to 1-5 had photoelectric conversion efficiencies of 15.0% or more, preferably 16.0% or more, and Manufacture Example 1-1, which included a light absorption layer formed with the coating agent of Example 1 having a DMPU used amount of 50 mol%, exhibited the best solar cell performance.

Through the above examples and experimental examples, it was confirmed that a large-area perovskite thin film with uniformity and no pinholes can be commercially manufactured, and it was confirmed that the perovskite solar cell manufactured using the same had a high photoelectric conversion efficiency.

## Claims

1. A coating agent for forming a large-area perovskite thin film, comprising a perovskite compound represented by Chemical Formula 1 below,
wherein the coating agent comprises a perovskite precursor, a crystallinity enhancer, a Lewis base and a solvent:
[Chemical Formula 1] AₘA'₁₋ₘB(XₙX'₁₋ₙ)₃
wherein in Chemical Formula 1, A is formamidinium (FA), ethylamine (EA), guanidinium (GA) or ethylenediamine (EDA), A' is Cs⁺, Na⁺, K⁺, NH₄⁺ or Rb⁺, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻ or I⁻, and m and n are rational numbers satisfying 0.7 ≤ m ≤ 0.9 and 0.1 ≤ n ≤0.3.

2. The coating agent of claim 1, wherein the perovskite precursor comprises an organic halide represented by Chemical Formula 2 below, a monovalent metal halide represented by Chemical Formula 3 below, a divalent metal halide represented by Chemical Formula 4 below and a divalent metal halide represented by Chemical Formula 5 below:
[Chemical Formula 2] AX
wherein in Chemical Formula 2, A is formamidinium (FA), ethylamine (EA), guanidinium (GA) or ethylenediamine (EDA), and X is Br⁻ or I⁻,
[Chemical Formula 3] A'X
wherein in Chemical Formula 3, A' is Cs⁺, Na⁺, K⁺, NH₄⁺ or Rb⁺, and X is Cl⁻, Br⁻ or I⁻, and
[Chemical Formula 4] BX₂
[Chemical Formula 5] BX'₂
wherein in Chemical Formula 4 and Chemical Formula 5, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻ or I⁻, and X and X' are different halogen anions.

3. The coating agent of claim 1, wherein the crystallization enhancer comprises at least one selected from CH₃NH₃Cl, CH₃NH₃Br and CH₃NH₃I,
wherein the Lewis base comprises at least one selected from N,N-dimethyl-propyleneurea (DMPU), hexamethylphosphoramide (HMPA) and N-methyl-2-pyrrolidone (NMP), and
wherein the solvent comprises at least one selected from dimethylformamide (DMF), γ-butyrolactone, 2-methoxyethanol, dimethyl sulfoxide (DMSO) and N-methyl-2-pyrrolidinone (NMP).

4. The coating agent of claim 1, wherein the coating agent comprises 15 to 30 mol% of the crystallinity enhancer and 40 to 100 mol% of the Lewis base based on 100 mol% of the perovskite precursor.

5. The coating agent of claim 3, wherein the coating agent comprises the solvent and the Lewis base in a volume ratio of 1:0.06 to 0.25.

6. A method for forming a large-area perovskite thin film having an area of 200 cm² or more, performing a process comprising:
step 1 of preparing the coating agent according to any one of claims 1 to 5;
step 2 of performing a coating process and drying the coating agent on an upper part of a substrate to form a wet-thin film comprising a perovskite crystallized in an intermediate phase; and
step 3 of performing an annealing process on the wet-thin film to form a large-area perovskite thin film comprising a perovskite compound represented by Chemical Formula 1 below:
[Chemical Formula 1] AₘA'₁₋ₘB(XₙX'₁₋ₙ)₃
wherein in Chemical Formula 1, A is formamidinium (FA), ethylamine (EA), guanidinium (GA) or ethylenediamine (EDA), A' is Cs⁺, Na⁺, K⁺, NH₄⁺ or Rb⁺, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻ or I⁻, and m and n are rational numbers satisfying 0.7 ≤ m ≤ 0.9 and 0.1 ≤ n ≤0.3.

7. The method of claim 6, wherein the upper part of the substrate on which the coating agent is coated is a Si thin film layer, a hole transport layer, an electron transport layer or a passivation layer.

8. The method of claim 6, wherein the coating process is performed by blade coating, slot die coating, bar coating, inkjet coating or spray coating.

9. The method of claim 6, wherein the drying is performed together with the coating process, or after the coating process is completed.

10. The method of claim 9, wherein the drying is performed by a knife blowing process to evaporate a solvent.

11. The method of claim 6, wherein the annealing is performed by heat treatment at 120 to 180°C for 5 to 20 minutes.
